# EUROPEAN PATENT APPLICATION

(11) **EP 2 388 763 A1**
(43) Date of publication of application: **23.11.2011**
(21) Application number: 10368026.0
(22) Date of filing: 19.05.2010
(51) Int. Cl.: G09G 3/32

(54) **PWM precharge of organic light emitting diodes**

(71) Applicant: Dialog Semiconductor GmbH, 73230 Kirchheim/Teck-Nabern (DE)
(72) Inventor: Allen, Stephen, Cambridge CB22 5JU (GB); Bramante, Nicola, Swindon, SN5 6JZ (GB); Jones, Kevin, Swindon, SN25 4 (GB); Somerville, Alan, Tokyo (JP); Tyrell, Julian, Swindon, SN6 6LU (GB); Bramante, Nicola, Swindon SN5 7XB (GB)
(74) Representative: Schuffenecker, Thierry

(57) **Abstract**

Methods for PWM precharging of organic light emitting diodes (OLEDs) have been disclosed. Image quality has been improved by including the light generated during pre-charge phase is included in the overall budget. The approach invented is especially beneficial to displays using Multi-Line Algorithms (MLA). Constant discharge time for anodes, discharging the anodes to just below the luminance level saves power by reducing the pre-charge requirements for the next driving phase. High impedance terminal (HiZ) discharge is performed after a fixed discharge of anodes.

## Description

### Technical field

This invention relates generally to the field of Light emitting diodes (LEDs) and relates more specifically to precharging of organic light emitting diodes (OLEDs).

### Background Art

An organic light emitting diode (OLED) display panel is an electronic device made by placing a series of organic thin films between two conductors. An organic light emitting diode (OLED) display panel is recognized as an image display device that will replace soon widely used liquid crystal displays (LCDs). When electrical current is applied, a bright light is emitted. This process is called electrophosphorescence. Even with the layered system, these systems are very thin, usually less than 500 nm (0.5 thousandths of a millimeter). Like an LED, an OLED is a solid-state semiconductor device that is 100 to 500 nanometers thick. OLEDs can have either two layers or more layers of organic material.

An OLED comprises a substrate supporting the OLED, an anode removing electrons (adds electron "holes") when a current, supplied by one or more current sources, flows through the device, and a cathode injects electrons when a current flows through the device and organic layers which are made of organic molecules or polymers.

OLED display panels do not require backlighting. These properties result in thin, very compact displays. Furthermore OLED display panels have significant advantages over LEDs, such as a wider viewing angle, reduced power consumption, lower voltage, increased brightness, faster response time, lighter weight, greater durability, and broader temperature ranges.

There are different types of OLED display panels, such as Passive-matrix OLEDs (PMOLEDs), Active-matrix OLEDs, Transparent OLEDs, Top-emitting OLED, Foldable OLEDs, and White OLEDs.

OLEDS pixels comprise a diode with a capacitance in parallel. Before a pixel reaches the diode threshold voltage, no current flows through the diode and the pixel is dark. Supply current is consumed only for charging the capacitor during this period. It may take a significant long time until the capacitor is charged above the diode's threshold voltage and the pixel is lit. Therefore the pixel might be dim and is difficult to be controlled.

Pre-charge driving solves these problems outlined above. The pixel voltage is set at a level where desirable diode current is attained in a short period. Current practice for pre-charging assumes either (1) a fixed pre-charge current for a time dependent on the final desired pixel brightness (with a table being used to match pre-charge time to drive current; or (2) a sample-and-hold circuit to sample the required pre-charge voltage and apply affixed pre-charge current sufficient to attain that voltage.

In both these cases the assumption is that the light generated during the pre-charge phase is minimal, such the grey-scale value of the pixel can be determined solely by Pulse-Width Modulation (PWM) of the drive phase and errors hidden within the gamma correction of the original image. The purpose of pre-charge is to attain the desired drive voltage as quickly as possible.

In reality, significant light is generated during the pre-charge phase, which the above schemes are only able to hide through gamma correction. In a multi-line drive scenario (a technique used to reduce peak current) it is not practical to hide the errors in gamma correction as this is not additive, and so a different mechanism should be employed.

The following problems exist with prior art:
1. Image quality because the light generated during pre-charge is not considered in the overall light budget.
2. Pre-charging applied with multi-line drive scenarios the errors cannot be hidden by gamma correction.
3. Correct discharge time for anodes in order to discharge the anodes just below the luminance level (pixel threshold).
4. Achieving a minimal discharge time for anodes without requiring a full discharge to ground.

Solutions dealing with pre-charge schemes for OLEDS are described in following patents:
U. S. Patent (US 7,403,176 to Chung et al.) discloses a pixel circuit of an organic EL display device wherein a gate of a driving transistor is coupled to a gate of a compensating transistor, which is configured to operate as a diode. A precharge voltage is applied to the gate of the driving transistor while a selection signal is applied to a previous scan line, so that the compensating transistor is biased in a forward direction to apply a data voltage on the gate of the drive transistor. The driving transistor may be electrically isolated from the organic EL element (OLED) while precharging, so as to prevent the OLED from emitting a light using the precharge voltage. In addition, the driving transistor may be electrically isolated from the OLED while the data voltage is being charged, so as to prevent the OLED from emitting a light.
U. S. Patent (US 7,126,568 to LeChevalier) proposes organic light emitting diode (OLED)/polymer OLED (PLED) displays and operation with a precharge latency. Particularly, precharging operation of such a display device with a precharge switch latency. According to the operation, a capacitive aspect of a display element is pre-charged, and the display element is activated so as to conducting a current therethrough. The precharging is terminated after the activation of the display element. Then a current is supplied and conducted through the display element for exposure of the display element. In this operation, a precharge droop that may occur during the transition between precharge and exposure can be avoided or minimized.
U. S. Patent Application Publication (US 2008/0272713 to Kang et al.) proposes a driving circuit using an internal diode instead of a zener diode and a discharging method using the same capable of replacing a driving circuit including an external zener diode, thereby reducing costs. The driving circuit using a discharging method for driving an OLED (organic light emitting diode) panel, the driving circuit includes: a precharge channel which is constructed in a current mirror scheme and is turned off when discharging; a discharge channel which is connected to the to precharge channel in series and operates when discharging; and an internal diode which is connected to the discharge channel and controls a discharge voltage level.

### Summary of the invention

A principal object of the present invention is to improve image quality of OLED displays.

A further object of the present invention is to improve image quality of OLED displays by including the light generated during a pre-charge phase in the overall light budget.

A further object of the present invention is to include the light generated during a pre-charge phase to multi-line drive scenarios using Multi-Line Algorithms (MLA).

A further object of the present invention is to achieve constant discharge times for anodes, discharging the anodes just below the luminance level of the OLED pixel.

Moreover an object of the present invention is to achieve that each anode is discharged to a same potential without requiring a full discharge to ground.

In accordance with the objects of this invention a method of a non-linear PWM pre-charge of organic light emitting diodes (OLEDs) has been achieved The method invented comprises, firstly, the steps of: (1) providing an OLED display comprising one or more current sources providing pixels with current as required and pixels having each an anode and a cathode, (2) address a pixel of the OLED display, and (3) pre-charging a pixel addressed until its illumination threshold. Furthermore the method comprises the steps of (4) defining a threshold at which a switch is performed from pre-charge to a drive phase of the pixel in terms of PWM count numbers used for pre-charge, (5) pre-charging the pixel to required forward voltage or to desired PWM count if that occurs first, and (6) adding light generated during pre-charge to a light budget desired of the pixel. Finally the method comprises the steps of: (7) driving the pixel with a current until overall light budget of the pixel including light generated during pre-charge is reached, and (8) discharging pixel selected to below illumination threshold.

### Description of the drawings

In the accompanying drawings forming a material part of this description, there is shown:
**Fig. 1** illustrates an ideal pre-charge case of an OLED pixel.
**Fig. 2** illustrates realistic pre-charge cases.
**Fig. 3** illustrates the relationship of drive PWM count upon luminosity.
**Fig. 4** illustrates a split of data for different pre-charge cases.
**Fig. 5** illustrates a PWM Pre-charge of the present invention.
**Figs. 6 a-c** illustrate different combinations of pre-charge and drive phases of the present invention.
**Fig. 7** shows variations of duration of PWM pre-charge dependent on amount of drive currents required.
**Fig. 8** shows an example of a PWM pre-charge table.
**Fig. 9** illustrates a flowchart of a method of a non-linear PWM pre-charge of OLEDs.

### Description of the preferred embodiments

The preferred embodiments disclose methods to achieve a pulse-with modulated (PWM) precharge of organic light emitting diode (OLED) pixels improving image quality. The invention is applicable to all kinds of passive matrix organic light emitting diodes (PMOLEDs) as these have repeated pre-charge and discharge cycles.

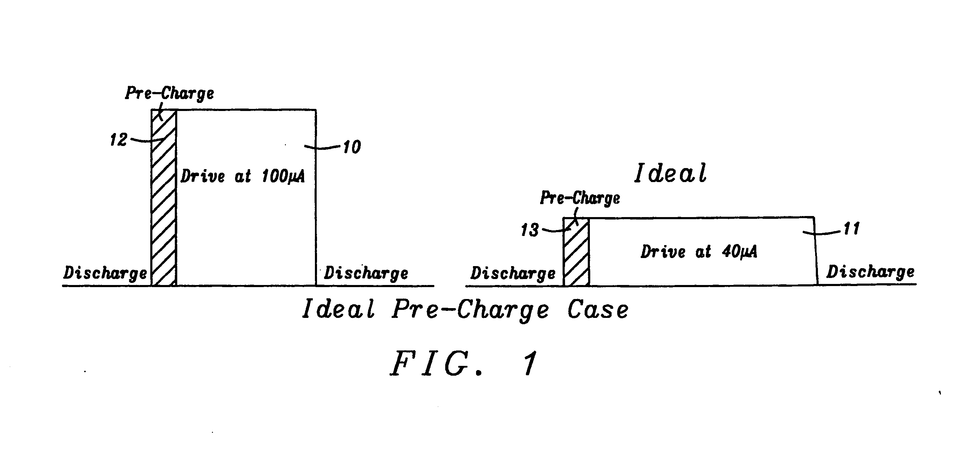

In an ideal case the OLED pixels would be pre-charged to the correct forward voltage for a given drive current, drive it for the appropriate time to give the correct pixel brightness and instantaneously discharge the OLED. The forward voltage required will vary with drive current as shown in **Fig. 1****.**

The methods invented could be applied e.g. for an PMOLED system

**Fig. 1** illustrates an ideal pre-charge case of an OLED pixel. It shows two ideal cases. A first case **10** requiring 100 µA to drive the OLED pixel and a second case **11** requiring 40 µA to drive the pixel. For each case the pre-charge current required is shown by the area **12** or correspondently by the area **13.**

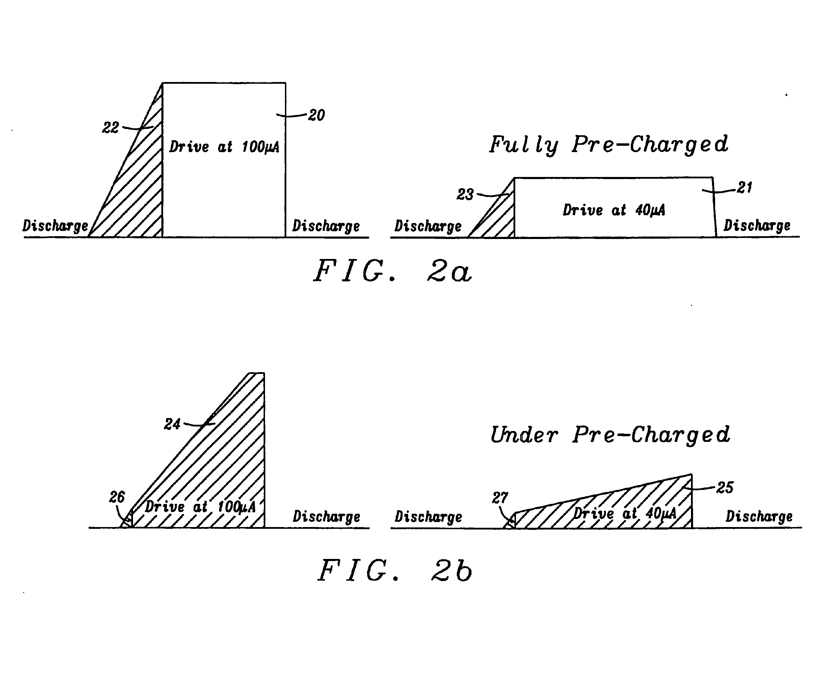

However there is a limited amount of current that can be both supplied by the driver and driven into the display. There are two choices in reality: (1) either fully precharge the display and have significant light in the pre-charge phase; or (2) under-precharge the display and compensate with the gamma correction table as shown in **Fig. 2****.**

**Fig. 2** illustrates realistic pre-charge cases. In the fully pre-charged cases **20** and **21,** wherein in case **20** a drive current of 100 µA is required and in case **21** a drive current of 40 µA is required, the pre-charge **22** or correspondently **23** is performed to the correct, full voltage and hence this pre-charge adds to the luminance (offset of luminance) delivered.

In the under pre-charged cases **24** and **25,** wherein in case **24** also a drive current of 100 µA is required and in case **25** a drive current of 40 µA is required, the pre-charge **26** or correspondently **27** is reduced and hence it doesn't contribute to luminance. Therefore drive current is lost to parasitic capacitances and the luminance drops (Luminance Vs PWM non-linear).

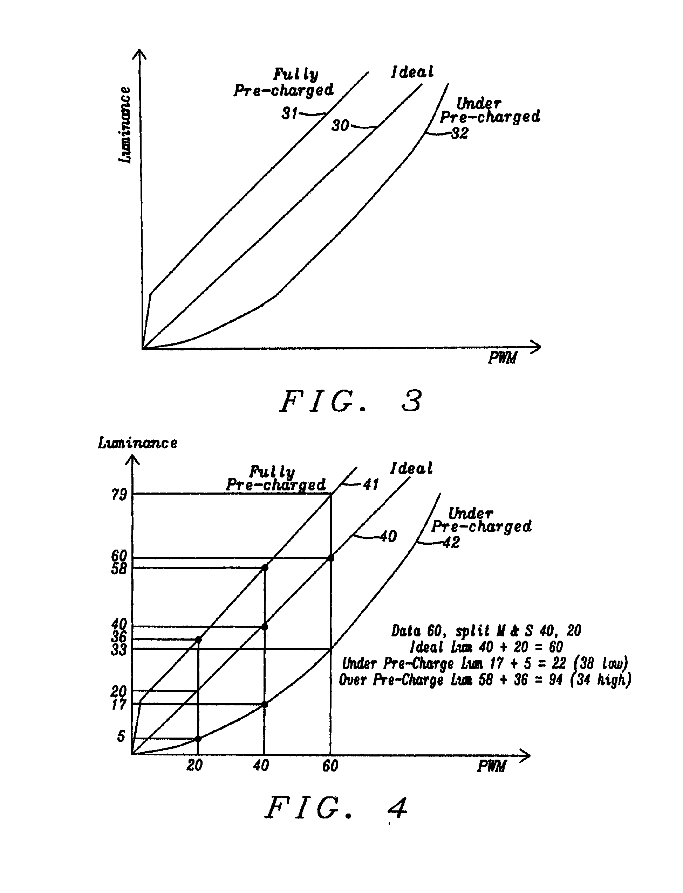

It has to be noted that pre-charge has a significant effect on the relationship between light (luminance) and PWM drive time as shown in **Fig. 3****.**

**Fig. 3** illustrates the relationship of drive PWM count upon luminosity. Curve **30** depicts an ideal case correspondently to the ideal case of **Fig. 1****.** Curve **31** shows the relationship between luminance and PWM count based on a fully pre-charge case and curve **32** shows the relationship between luminance and PWM count based on an under pre-charge case.

Conventional PMOLED drivers follow the under pre-charge curve by charging to the point of illumination and then "straightening" the curve by including an inverse curve within a gamma correction. This has two disadvantages: (1) it reduces the dynamic range of the display, and (2) it decreases the brightness of the display because it attempts to overcome the parasitic capacitance of the display with the drive current, which is lower than the pre-charge current and therefore requires more time to reach the luminance desired.

It should be noted that the present invention could be applied for multi-line addressing (MLA) schemes such as e.g. Common Multi-Line Addressing (CMLA) or Advanced Multi-Line Addressing (AMLA). In a multi-line drive scenario, where the original image is decomposed into a number of lower resolution images such that the lower-resolution images can be driven in less time than the original image and a saving of time is made resulting in lower current, lower power, and longer lifetime of the display. The decomposition process assumes that the pixels are additive in term of PWM counts for a given luminosity. Thus, if a pixel has a PWM count number of 100, it can be driven as two images of PWM count number 10 and 90, or 50 and 50, or 60 and 40, and the luminosity will be the same. Any errors introduced in the translation of PWM to luminosity will also be additive and so it is important that this kind of errors are small or non-existent.

**Fig. 4** illustrates a split of data for different pre-charge cases. For example a PWM count of 60 has been split between two planes (e.g. M & S plane) as 20 plus 40. In the ideal linear case of line **40** the 40 PWM case and 20 PWM case combine to give the same luminosity 40 + 20 = 60 as the original 60 PWM count. In the fully/over pre-charged case of line **41** the additional light during the pre-charge phase results in a combined luminosity 58 + 36 = 94 equivalent to a PWM count of 94 (i.e. higher by 34 than the ideal case), whereas in the under pre-charged case of line **42** we see a combined luminosity 17 + 5 = 22 equivalent to a PWM count of 22 (i.e. 38 lower than the ideal case).

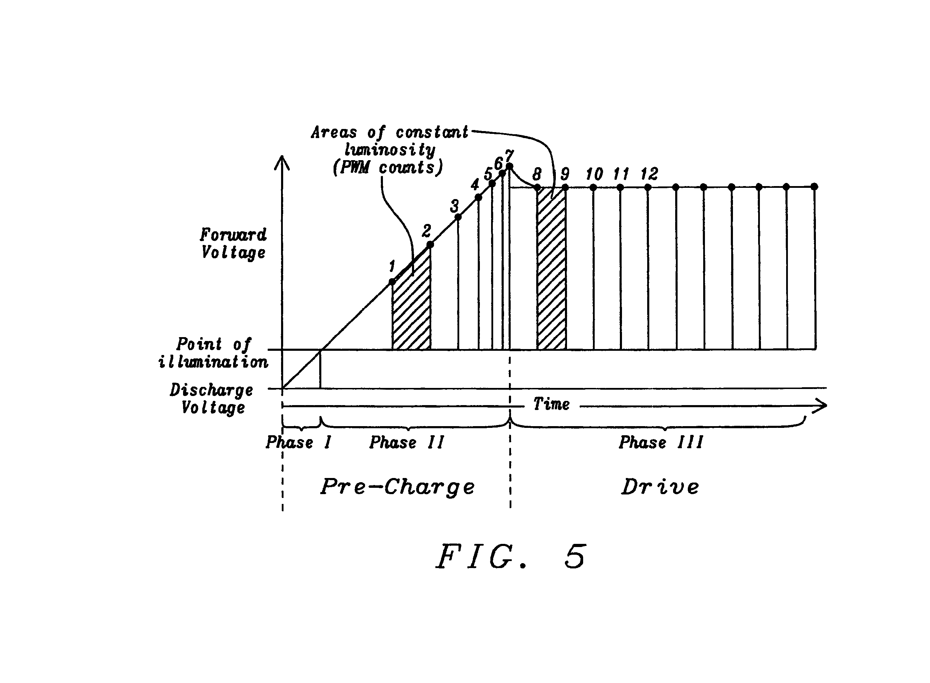

A key item of the present invention comprises including the PWM count within the pre-charge stage, and split the pre-charge stage in two distinct phases: (1) pre-charge to point of illumination; then (2) pre-charge to the required forward voltage, or to the desired PWM count if that occurs first. This is illustrated in **Fig.5****.**

**Fig. 5** illustrates a PWM Pre-charge of the present invention. The PWM pre-charge of the present invention has two phases. Pre-charge phase 1 is used to charge the OLED to the point of illumination (illumination threshold). Once the point of illumination has been achieved light is generated and Phase 2 is started. Light generated during this second pre-charge phase is not directly proportional to time as part of the pre-charge current is used to generate light and another part of the pre-charge current is used to charge the OLED. For example, the time taken to reach the first PWM unit of light is longer than the time taken to reach PWM point 2. Once the desired forward voltage is reached the drive phase is switched to. Light generated during the drive phase is directly proportional to time and each area of constant luminosity has the same time period. For example the delta time between points 8 and 9 showed in **Fig. 5** is identical to the delta time between points 9 and 10. Also for example the area between points 1 and 2 and the area between points 8 and 9 are areas of constant luminosity (PWM counts).

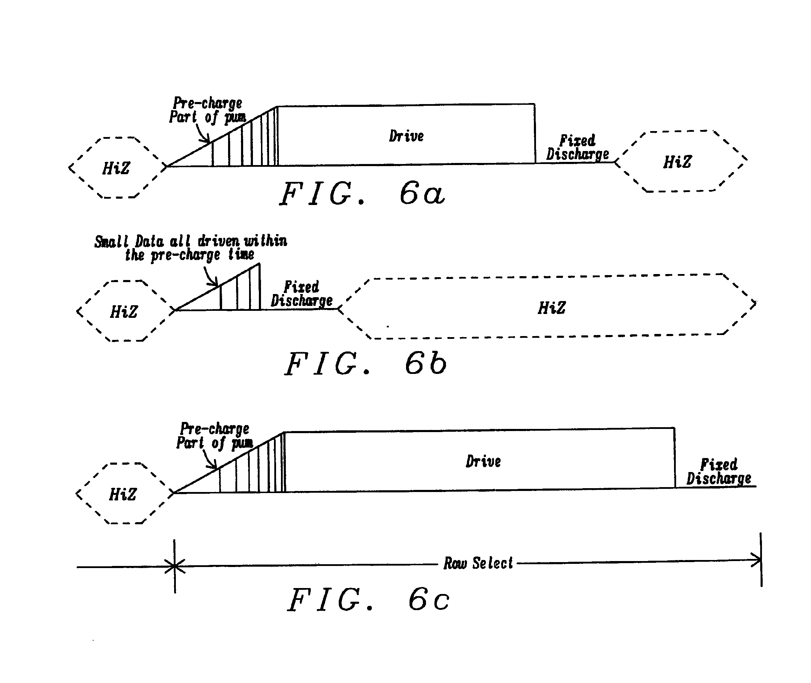

For small PWM counts it is likely that the drive phase is never entered at all, as all desired light is generated already during the pre-charge phase. This is illustrated in **Fig. 6 a-c.**

**Figs. 6 a-c** illustrate different combinations of pre-charge and drive phases of the present invention. **Figs. 6 a-c** also illustrates the uses of a fixed discharge followed by a high impedance terminal **(Hiz)** period that allows the OLED to be discharged to below illumination point rather than fully to ground, allowing the phase 1 period of the pre-charge, as shown in **Fig. 5****,** to be reduced or eliminated, thus saving power.

It should be noted that HiZ discharge is just one of other possible methods used for discharge as e.g. minimum discharge or discharge to a voltage over ground voltage. HiZ discharge simply disconnects the current source from the anode to let the anode float (or enter a state of HiZ). The cathode is then connected to the discharge voltage (normally GND).

The fixed discharge is performed to a voltage lower than the illumination voltage. This could be a voltage higher than ground voltage (GND), but most likely will be GND as this is the lowest cost solution.

**Figs. 6 a-c** shows three cases all starting with a **HiZ** phase. It should be noted that the HiZ phases shown in **Figs. 6 a-c** signify the end of a previous line. The **HiZ** phase comes of course at the end of a line.

**Fig. 6a** illustrates an OLED pixel cycle starting with a HIZ period, followed by a PWM precharge phase until the forward voltage, required for the drive phase, is reached, generating also a part of the light desired, as described in **Fig. 5****,** next is a drive phase, generating the rest of the light desired, followed by a first phase of discharge, namely a fixed discharge of the OLED capacitances and by a second phase of discharge, namely a **HiZ** discharge, discharging below luminance point rather than fully to ground.

**Fig. 6b** illustrates an OLED pixel cycle having a small PWM count, starting with a HIZ period, followed by a PWM precharge phase, generating all the light desired during the PWM precharge phase because of the small PWM count. Therefore no drive phase is required in this case. Right after the PWM pre-charge, which may be shorter than in the case of Fig. 6a, follows a fixed discharge and then a HiZ period. The discharge is actually entirely controlled by the fixed discharge period. During the Hi-Z period the OLED is no longer discharging. The **HiZ** time for each pixel (as illustrated by a-c) can then be different and will take the time to the end of the pixel drive time of the brightest pixel in the row.

**Fig. 6c** illustrates an OLED pixel cycle, wherein a high amount of light has to be generated having therefore a long drive phase followed by fixed discharge until the end of the ROW select phase.

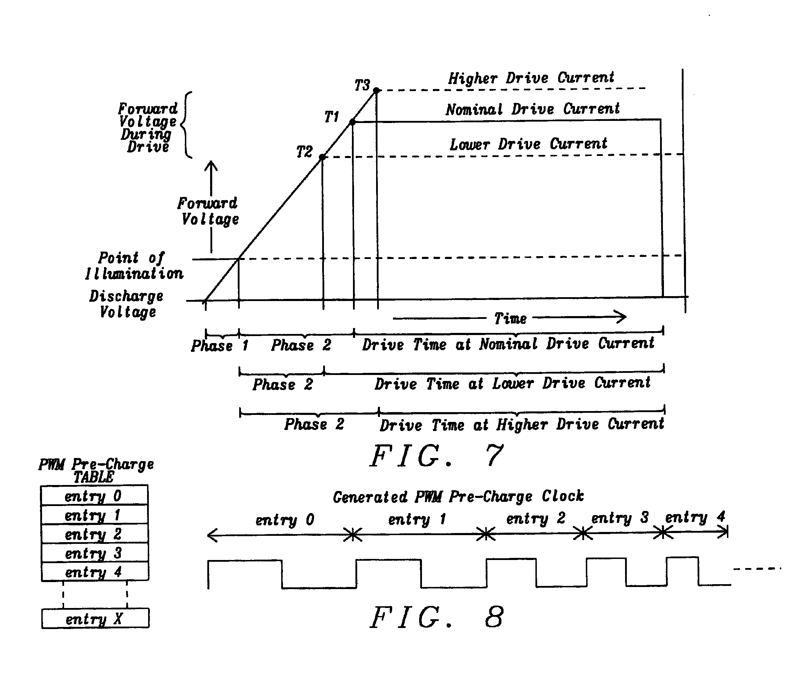

The point at which the transition from PWM pre-charge to Drive phase is performed is not fixed. It depends on the amount of drive current, as this in turn determines the operation forward voltage of the OLED. The contribution of the pre-charge to the total light budget desired will therefore vary with the proposed drive current. This is shown in **Fig. 7****.**

**Fig. 7** shows variations of duration of PWM pre-charge dependent on amount of drive currents required. The point of time **T1** in **Fig. 7** illustrates the transition from PWM pre-charge to a nominal drive current, **T2** illustrates the transition from PWM pre-charge to a lower than nominal drive current, and **T3** illustrates the transition from PWM pre-charge to a higher than nominal drive current.

One possible method of implementation of the method invented is to use a table to produce the variable width PWM clock for the pre-charge charge phase. Another possible method would be a calculation of the variable PWM clock on the fly using a parametrized equation.

An example for such a table is shown in **Fig. 8****.** Each entry in the table represents the time needed to generate one PWM unit of light. As each entry in the table represents a PWM count, it is possible therefore to define the threshold value at which we switch from pre-charge to drive in terms of PWM values (this would be the PWM value at e.g. T1, T2 or T3 in **Fig.7**). All timing is now defined in terms of PWM counts and thus automatically accommodates the light generated during pre-charge in the overall light budget. If a single threshold value does not provide sufficient resolution then a fractional value can be used to increase the accuracy.

In **Fig. 7** it was assumed that drive time and current had been traded to increase lifetime and reduced power at the same brightness, such that each PWM count represents a constant and clearly defined unit of brightness. It is also possible that either drive current, driving time, or both drive current and driving time, are varied to change the brightness such that the PWM counts within both the pre-charge and drive phase represent new constant level of brightness.

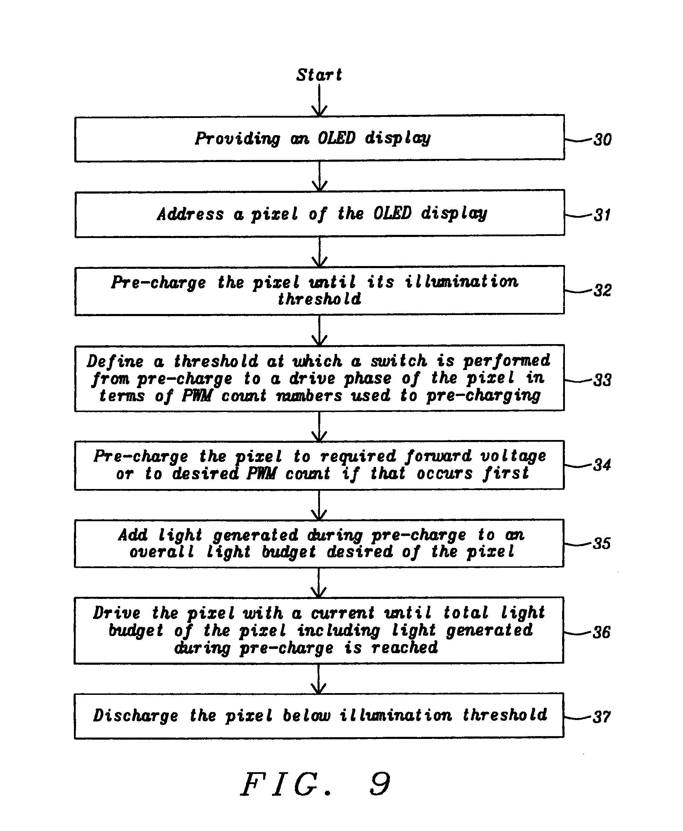

**Fig. 9** illustrates a flowchart of a method of a non-linear PWM pre-charge of OLEDs. A first step **90** describes the provision of an OLED display comprising one or more current sources providing pixels with current as required and pixels having each an anode and a cathode. Step **91** illustrates addressing a pixel of the OLED display. Step **92** depicts pre-charging the pixel addressed until its illumination threshold. Step **93** describes defining a threshold at which a switch is performed from pre-charge to a drive phase of the pixel in terms of PWM count numbers used for pre-charge. In step **94** the pixel is pre-charged to required forward voltage or to desired PWM count if that occurs first. In step **95** light generated during pre-charge is added to an overall light budget desired of the pixel. Step **96** describes driving the pixel with a current until overall light budget of the pixel including light generated during pre-charge is reached and step **97** illustrates discharging pixel below illumination threshold.

The concept of a preferred embodiment of the invention comprising a non-linear PWM period described here could be also extended to a voltage driving scheme or a fixed current driving scheme.

It should be noted that the method described in **Fig. 9** could be applied favorably to OLED displays using Multi-Line Algorithms (MLA).

In summary, the following improvements are obtained by the present invention:
- The image quality is improved by including the light generated during the pre-charge phase in the overall light budget.
- The method invented is particularly beneficial to Multi-Line Algorithms (MLA) where images are composed of lower resolution sub-images. The sub-images are summed together to from the complete image, and as such will often have low-level gray-scaled components where the light generated during the drive phase is comparable to that generated during pre-charge.
- Constant discharge time for anodes, discharging the anodes to just below the luminance level saves power by reducing the pre-charge requirements for the next driving phase.
- Constant discharge time for anodes will result in each anode being discharged to the same potential without requiring a full discharge to ground, reducing the required discharge time to a minimum and thus allowing the drive time to be maximized. Conventionally all the anodes must be fully discharged to ground to prevent artifacts caused by residual potentials to different magnitudes being left on the anodes at the start of the next phase.

While the invention has been particularly shown and described with reference to the preferred embodiments thereof, it will be understood by those skilled in the art that various changes in form and details may be made without departing from the spirit and scope of the invention.

## Claims

1. A method of a non-linear PWM pre-charge of organic light emitting diodes (OLEDs) comprising the steps of:
(1) providing an OLED display comprising one or more current sources providing pixels with current as required and pixels having each an anode and a cathode;
(2) address a pixel of the OLED display;
(3) pre-charging a pixel addressed until its illumination threshold;
(4) defining a threshold at which a switch is performed from pre-charge to a drive phase of the pixel in terms of PWM count numbers used for pre-charge;
(5) pre-charging the pixel to required forward voltage or to desired PWM count if that occurs first;
(6) adding light generated during pre-charge to a light budget desired of the pixel;
(7) driving the pixel with a current until overall light budget of the pixel including light generated during pre-charge is reached; and
(8) discharging pixel selected to below illumination threshold.

2. The method of claim 1 wherein said discharging of the pixel selected is performed by a fixed discharge wherein said fixed discharged is performed to a level lower than said illumination threshold.

3. The method of claim 2 wherein said discharge is performed to ground voltage.

4. The method of claim 2 wherein a second phase of discharging follows said fixed discharge.

5. The method of claim 4 wherein said second phase of discharging is a high impedance terminal (HiZ) discharge, wherein the HiZ discharge disconnects a current source from an anode of the pixel to let the anode float.

6. The method of claim 1 wherein time for driving the pixel and strength of driving current is traded to increase lifetime of the pixel and reduce power required.

7. The method of claim 1 wherein a table is used to produce a variable width of PWM clock for the pre-charge phase.

8. The method of claim 7 wherein each entry of the table represents a time needed to generate one PWM unit of light.

9. The method of claim 7 wherein said threshold from the pre-charge phase to a drive phase is defined using said table.

10. The method of claim 1 wherein all timing of the pre-charge is defined in terms of PWM counts.

11. The method of claim 1 wherein a parametrized equation is used to calculate a variable width of PWM clock for the pre-charge phase.

12. The method of claim 1 wherein no drive current is driven through the pixel if luminance desired has already been generated during the pre-charge phase.

13. The method of claim 1 wherein either drive current, driving time, or both drive current and driving time, are varied to change brightness of the pixel such that PWM counts within both the pre-charge and drive phase represent new constant level of brightness

14. The method of claim 1 wherein said method is applied for OLED displays using multi-line addressing algorithms.

15. The method of claim 14 wherein images are composed of lower resolution sub-images.

16. The method of claim 14 wherein Common Multi-Line Addressing is applied or, alternatively, wherein Advanced Multi-Line Addressing is applied.

17. The method of claim 1 wherein a constant discharge time for anodes is resulting in each anode being discharged to a same potential without requiring a full discharge to ground voltage.

18. The method of claim 1 wherein said PWM count is split between multiple planes or between two planes.
